# EUROPEAN PATENT APPLICATION

(11) **EP 1 688 247 A1**
(43) Date of publication of application: **09.08.2006**
(21) Application number: 04819394.0
(22) Date of filing: 25.11.2004
(51) Int. Cl.: B32B 15/08, H05K 3/06, H05K 3/24

(54) **METAL-CLAD SUBSTRATE AND METHOD FOR PRODUCING SAME**

(30) Priority: 26.11.2003 JP 2003395447
(71) Applicant: Dowa Mining Co., Ltd, Chiyoda-ku Tokyo 101-8617 (JP)
(72) Inventor: KOHAYASHI, Shuichi, Chiyoda-ku, Tokyo 100-8282 (JP); SAWABE, Akio, Chiyoda-ku, Tokyo 100-8282 (JP); KITAMURA, Yukihiro, Chiyoda-ku, Tokyo 100-8282 (JP)
(74) Representative: Grünecker, Kinkeldey, Stockmair & Schwanhäusser Anwaltssozietät
(86) International application number: PCT/JP2004/017470
(87) International publication number: WO 2005/051652

(57) **Abstract**

To provide a metal-coated substrate capable of significantly improving an adhesion strength and stability between metal and a plastic film. By laminating a thermoplastic film layer 2 on a base body plastic film layer 3 to obtain a laminated plastic film, and a metal layer 1 is formed on the thermoplastic film layer 2, while controlling a temperature of the laminated plastic film.

## Description

### Technical field of the invention

The present invention relates to a metal-coated substrate in which a metal layer is provided on a plastic film, and which is preferably used in a flexible circuit board, a flexible wiring board, or a TAB tape and so forth, and a manufacturing method of the same.

A metal-coated substrate formed of a metal layer provided on a plastic film is an indispensable material for obtaining a high-density packaged electronic device such as a cellular phone and a digital camera, wherein a circuit is formed by a metal-coated portion and a microchip such as an IC and a capacitor is loaded on the circuit in some cases.

As the metal layer of this kind of metal-coated substrate, copper is most frequently used, from an aspect of cost, processability, electric characteristics, and migration resistance. Also, as a plastic film, which is a substrate material, various plastic films are used according to the purpose of the metal-coated substrate. However, when the microchip is solder-joined on a conductive circuit of the metal layer processed in high precision/fineness, an advanced thermal dimensional stability is required, and therefore a polyimide film is preferably used, which is thermally stable and having less difference between linear expansion coefficients of the polyimide film and the metal layer.

A manufacturing method of the metal-coated substrate includes:
(1) A method whereby a copper foil is previously prepared by electrolysis or rolling, and the copper foil thus prepared is bonded to a plastic film by adhesive,
(2) A casting method whereby a precursor of the plastic film is applied on the copper foil to be polymerized thereinto not through adhesive, and the copper foil and the plastic film are bonded to each other (for example, see patent document 1),
(3) A laminate method whereby a thermoplastic film is stacked and laminated on the copper foil, so that the copper foil and the plastic film are bonded to each other (for example, see patent document 2),
(4) A vapor-deposition plating method whereby a metal is thinly applied on the plastic film by sputtering, etc, and metal is applied by plating on the coated metal up to a predetermined thickness (for example, see patent document 3).

The metal-coated substrate manufactured by a method not using adhesive, etc, such as (2) casting method and (3) laminate method, has a comparatively excellent high temperature adhesiveness, and therefore is used for the purpose of mounting chip parts. However, along with a technical development of recent years, high-density packaging is further requested, and a thinner coated-metal is further requested for coping with a high precision/fineness of the circuit.

In order to satisfy such a request, in the casting method and the laminate method, the copper foil is made thin as much as possible, and by using such a copper foil, the plastic film is cast-formed or stacked and laminated. However, there is a limit in manufacturing such a thin copper film or bonding the same. For example, even if the copper foil with a film thickness of 9 µm or less is manufactured by electrolysis or rolling, a handling property is inferior during a pasting process, and wrinkles, etc, are invited.

Therefore, in order to improve the handling property and prevent the wrinkles, the following methods are adopted:
the method whereby a thick copper foil is previously stuck on the plastic film, and in the following step, the copper foil is thinned by etching with chemicals;
the method whereby a buffer layer is previously laminated in the metal layer, and thinning of the metal layer is achieved by peeling off the buffer layer after laminating the metal layer (for example, see patent document 4).

Meanwhile, in the aforementioned vapor deposition plating method (4), a thin metal layer can be applied on the plastic film at a comparatively low cost, although involving the problem that a close adhesion between the plastic film and the coated metal is significantly deteriorated compared to other method.

As the method of solving the problem that the close adhesion between the plastic film and the coated metal is significantly deteriorated, the method of modifying the surface of the plastic film (polyimide film) by plasma processing before deposition plating is proposed. (for example, see non-patent document 1).
Patent document 1 : Japanese Patent Laid Open No.60-157286
Patent document 2 : US Patent NO.4543295
Patent document 3 : Japanese Patent Laid Open No.61-47015
Patent document 4 : Japanese Patent Laid Open No.2001-30847 Non-patent document : Vacuum Vol. 39 , first edition (issued in 1996)

### Disclosure of the invention

### Problem to be solved

In the method of bonding the copper foil and the plastic film by using the aforementioned adhesive (1), since the close adhesion of the copper foil and the plastic film at high temperature is deteriorated, there is a problem that a predetermined chip part can not be laminated by using a solder material which requires adhesive treating at high temperature.

In addition, in the aforementioned casting method (2), a productivity is low because of a difficult etching technique of uniformly etching the metal layer in the following step, and in the laminate method (3), two or more kinds of metal foils are laminated when the laminate method and the method of providing the buffer layer are used together. As a result, in either method, a manufacturing step is complicated, and the cost is increased.

Further, in the aforementioned deposition plating method (4), when the plasma processing is performed to the plastic film before deposition plating, it is confirmed that bond of ketone group such as C-C and C-N bond in the polyimide film is cut to form a functional group, and the functional group thus formed is ionic-bonded with the coated metal, thereby improving the adhesiveness between the metal layer and the polyimide film to some extent. However, only by forming the functional group, although some improvement in adhesiveness between the metal layer and the plastic film is observed, a sufficient adhesiveness is not obtained as seen in a bent part of a cellular phone subjected to solder treatment so as to satisfy a heat-resistance at high temperature.

In view of the above-described circumstances, the present invention is provided, and an object of the present invention is to provide a metal-coated substrate capable of realizing a significant improvement of adhesive strength and stability between metal and the plastic film, when a metal coat is formed on the plastic film while preventing a cost from increasing as much as possible.

### Means to solve the problem

In order to solve the above-described problem, the inventors of the present invention find the following points:
In a metal-coated substrate, by selecting a combination of the plastic film layer of a first layer as a base body of a substrate and a metal layer, a difference between linear expansion coefficients of both is set below a predetermined value;
by interposing a thermoplastic film containing a thermoplastic between the base body of the plastic film layer and the metal layer, to form a laminated plastic film, and when the metal layer is formed on the laminated plastic film by a vapor deposition method, an adhesive strength and stability between metal and the plastic film is significantly improved,
thus achieving the present invention.

Therefore, the present invention takes several aspects as follows.

In a first aspect, a metal-coated substrate is provided, having a metal layer provided on one side or both sides of a laminated plastic film having a plurality of plastic film layers, the laminated plastic film comprising:
a plastic film layer as at least a base body; and
a thermoplastic film layer including thermoplastic,
wherein the plastic film layer as the base body has 15 × 10⁻⁶/K or less of a difference between linear expansion coefficients of the plastic film layer and the metal layer, and the metal layer is formed on the thermoplastic film layer by a vapor deposition method.

In a second aspect, the metal-coated substrate according to the first aspect is provided, wherein a glass transition temperature of the thermoplastic contained in the thermoplastic film layer is 180° or more.

In a third aspect, the metal-coated substrate according to either of the first or second aspect is provided, wherein the metal layer is formed, with a temperature of the laminated plastic film controlled at the temperature from the temperature lower than the glass transition temperature of the thermoplastic film by 100°C to lower than a decomposition temperature of the thermoplastic film.

In a fourth aspect, the metal-coated substrate according to any one of the first to third aspects is provided, wherein more than one kind of elements selected form Si, Ti, and Al are contained from a joining interface between the metal layer and the thermoplastic film layer toward the metal layer.

In a fifth aspect, the metal-coated substrate according to any one of the first to fourth aspects is provided, wherein the vapor deposition method is a sputtering method or an ion plating method.

In a sixth aspect, the metal-coated substrate according to any one of the first to fifth aspects is provided, wherein a pulling elasticity modulus of the laminated plastic film layer is 1000MPa or more.

In a seventh aspect, the metal-coated substrate according to any one of the first to sixth aspects is provided, wherein the metal layer is further laminated by a plating method on the metal layer formed by the vapor deposition method.

In an eighth aspect, a manufacturing method of a metal-coated substrate is provided, which is the manufacturing method of the metal-coated substrate having a metal layer provided on one side or both sides of a laminated plastic film having a plurality of plastic film layers, comprising:
selecting a plastic film layer as a base body having a difference between linear expansion coefficients of 15 × 10⁻⁶/K or less of the laminated plastic film and the metal layer in the laminated plastic film;
forming a thermoplastic film containing thermoplastic on one side or both sides of the plastic film layer as a base body; and thereafter
forming the metal layer on the thermoplastic film layer by a vapor deposition method.

In a ninth aspect, the manufacturing method of the metal-coated substrate according to the eighth aspect is provided, wherein when the metal layer is formed, a temperature of the laminated plastic film layer is controlled at the temperature from the temperature lower than the glass transition temperature of the thermoplastic film by 100°C to lower than a decomposition temperature of the thermoplastic film.

In a tenth aspect, the manufacturing method of the metal-coated substrate according to the ninth aspect is provided, wherein before the metal layer is formed, an organic substance containing more than one kind of elements selected from Si, Ti, and Al is deposited on the thermoplastic film layer.

In an eleventh aspect, the manufacturing method of the metal-coated substrate according to the tenth aspect is provided, comprising the steps of:
allowing the organic substance containing more than one kind of elements selected from Si, Ti, and Al to be deposited on the thermoplastic film layer before the metal layer is formed; and
heat-treating at 150°C the laminated plastic film having the organic substance containing more than one kind of elements selected form the Si, Ti, and Al deposited thereon.

In a twelfth aspect, the manufacturing method of the metal-coated substrate according to the eleventh aspect is provided, comprising the steps of:
allowing the organic substance containing more than one kind of elements selected form Si, Ti, and Al to be deposited on the thermoplastic film layer before the metal layer is formed; and
heat-treating at 150°C the laminated plastic film having the organic substance containing more than one kind of elements selected from the Si, Ti, and Al deposited thereon,
wherein the above two steps are simultaneously performed.

In a thirteenth aspect, the manufacturing method of the metal-coated substrate according to any one of the eighth to twelfth aspects is provided wherein as a vapor deposition method for forming the metal layer, a sputtering method or an ion plating method is performed.

In a fourteenth aspect, the manufacturing method of the metal-coated substrate according to any one of the eighth to thirteenth aspects is provided, comprising:
a plating film-forming step by a plating method for laminating the same kind or different kind of metal layer on the metal layer formed by the vapor deposition method.

In a fifteenth aspect, the manufacturing method of the metal-coated substrate according to the fourteenth aspect is provided, wherein after the metal layer is formed by the vapor deposition method, or after the plating film forming step, by etching the metal layer, a predetermined circuit pattern is formed on the metal layer.

In a sixteenth aspect, the manufacturing method of the metal-coated substrate according to either of the fourteenth or fifteenth aspect is provided, comprising the steps of:
forming a predetermined circuit pattern by providing a resist film on the metal layer formed by the vapor deposition method;
laminating the same or different kind of metal layer by a plating method on the metal layer having the circuit pattern formed thereon; and
removing the resist film, and removing the metal layer under the resist film thus removed,
wherein a predetermined circuit pattern is formed on the metal layer.

### Advantages

According to the metal-coated substrate of the first aspect, in the metal-coated substrate having a metal layer applied on the laminated plastic film wherein the plastic film as a base body and the thermoplastic film layer are laminated, the base body plastic film layer is the plastic film layer having 15 × 10⁻⁶/K or less of a difference between linear expansion coefficients of the plastic film layer and the metal layer, the thermoplastic film layer containing thermoplastic on one side or both sides of the base body plastic film layer is laminated, and the metal layer formed by the vapor deposition method is laminated on the thermoplastic film layer. Therefore, adhesiveness between each layer is significantly enhanced, and the adhesiveness of each inter-layer and dimension stability after heat treatment to the metal-coated substrate is excellent.

According to the metal-coated substrate of the second aspect, the thermoplastic film layer has the glass transition temperature of 180° or more. Therefore, the adhesive strength between the metal layer and the plastic film layer, and the adhesiveness and dimension stability of each inter-layer after heat treatment to the metal-coated substrate are excellent.

According to the metal-coated substrate of the third aspect, the metal layer is formed by the vapor deposition method, with a temperature of the laminated plastic film controlled at the temperature from the temperature lower than the glass transition temperature of the thermoplastic film by 100°C to lower than a decomposition temperature of the thermoplastic film. Therefore, the adhesive strength between the metal layer and the plastic film layer, and the adhesiveness and dimension stability of each inter-layer after heat-treatment to the metal-coated substrate are excellent.

According to the fourth aspect, the metal-coated substrate has an excellent adhesive strength between the metal layer and the plastic film layer.

According to the fifth aspect, the metal layer is formed by the sputtering method or the ion plating method. Therefore, the adhesive strength between the metal layer and the plastic film layer, and the adhesiveness of each inter-layer after heat-treatment to the metal-coated substrate are significantly increased.

According to the metal-coated substrate of the sixth aspect, the pulling elasticity modulus of the laminated plastic film layer formed of the base body plastic film layer and the thermoplastic film layer is 1000Mpa or more. Therefore, a mechanical strength is excellent.

According to the metal-coated substrate of the seventh aspect, the metal layer formed by the plating method is further laminated on the metal layer formed by the vapor deposition method. Therefore, a high film forming efficiency of the metal layer is obtained, thus realizing the metal-coated substrate having a high adhesive strength and stability between the metal layer and the plastic at a low cast.

According to the manufacturing method of the metal-coated substrate of the eighth aspect, the laminated plastic film is manufactured by laminating the thermoplastic film layer on the base body plastic film layer having the difference in the linear expansion coefficients of 15 × 10⁻⁶/K or less between the metal layer and the plastic film layer, and thereafter metal is applied on the surface of the thermoplastic film layer by using the vapor deposition method. Therefore, an ultra-thin metal-coated substrate having a high adhesive strength and close adhesion between the metal layer and the plastic film, and an excellent mechanical strength and dimension stability can be obtained at a low cost.

According to the manufacturing method of the metal-coated substrate of the ninth aspect, when the metal layer is formed by using the vapor deposition method, the temperature of the thermoplastic film layer is controlled at the temperature from the temperature lower than the glass transition temperature of the thermoplastic film contained in the thermoplastic film layer by 100°C to lower than a decomposition temperature of the thermoplastic film. Therefore, the adhesive strength and the close adhesion between the metal layer and the plastic film are significantly increased.

According to the manufacturing method of the tenth aspect, the metal-coated substrate having an excellent adhesiveness between the metal layer and the plastic film layer can be obtained.

According to the manufacturing method of the metal-coated substrate of the eleventh aspect, the metal-coated substrate having the excellent adhesive strength between the metal layer and the plastic film layer can be obtained.

According to the manufacturing method of the metal-coated substrate of the twelfth aspect, the metal-coated substrate having the excellent adhesive strength between the metal layer and the plastic film layer can be obtained with high productivity.

According to the manufacturing method of the metal-coated substrate of the thirteenth aspect, the vapor deposition method for applying metal is the sputtering method or the ion plating method. Therefore, the adhesive strength and the close adhesion between the metal layer and the plastic film can be further increased.

According to the manufacturing method of the metal-coated substrate of the fourteenth aspect, the same kind or different kind of metal layers are further laminated by the plating method on the metal layer formed by the vapor deposition method. Therefore, a thickness and kind of the metal layer can be freely selected and efficiently controlled.

According to the manufacturing method of the metal-coated substrate of the fifteenth aspect, by etching the metal layer, the substrate having a predetermined circuit pattern formed on a metal layer part can be obtained.

According to the manufacturing method of the metal-coated substrate of the sixteenth aspect, even if a pitch of the pattern is narrow, the thickness of the metal layer is increased, and a circuit pattern with high precision and low resistance can be formed.

### Best mode for carrying out the invention

Preferred embodiments of the present invention will be explained hereafter.

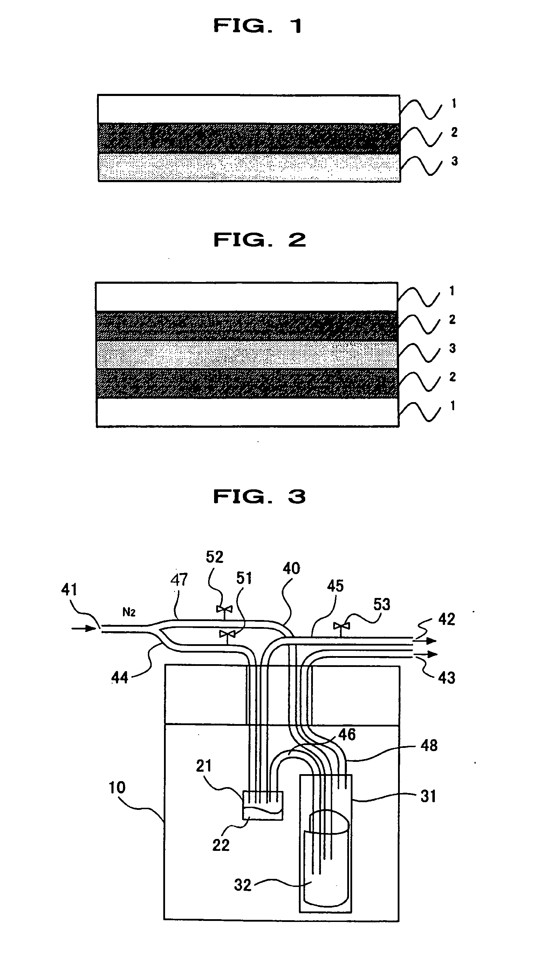

A metal-coated substrate according to the embodiments of the present invention is designed in such a way that a laminated film of the base body plastic film layer and a thermoplastic film layer is formed, thereafter a metal layer is applied on the thermoplastic film by a vapor deposition method such as a sputtering method or ion plating method, and the metal layer is further formed by lamination on the metal layer by the plating method. Fig. 1 shows a type of laminating the metal layer only on one side, and Fig. 2 shows a sectional view of the type of laminating the metal layer on both sides. In each figure, designation mark 1 denotes the metal layer, designation mark 2 denotes the thermoplastic film layer, and the designation mark 3 denotes the base body plastic film layer. The base body plastic film layer according to the embodiments of the present invention is selected, which has a difference in linear expansion coefficients of 15 × 10⁻⁶ /K or less between the plastic film layer and the metal layer.

In order to obtain the metal-coated substrate of the embodiment, a precursor of the base body plastic film and the thermoplastic film is prepared, and from the precursor thus prepared, the laminated plastic film is manufactured. In manufacturing the laminated plastic film, the base body plastic film and the thermoplastic film may be simultaneously formed or may be sequentially formed.

First, the step of simultaneously forming the base body plastic film and the thermoplastic film will be explained.

In this case, the precursor of the base body plastic film and the thermoplastic film is sequentially molded individually on a substrate of a flat and smooth metal or plastic, or molded into a film by using a multi-layer extrusion die. A molding order may be selected in either way of molding a base body plastic film precursor before molding a thermoplastic film precursor, or vice versa, when manufacturing one side metal-coated substrate. When both sides metal-coated substrate is manufactured, the thermoplastic film precursor, the base body plastic film precursor, and the thermoplastic film precursor are laminated in this order.

Next, a precursor molding film thus obtained is heated and dried at 80°C to 140°C or around to evaporate a solvent, thereby partially promoting a polymerization, and a self-supporting gel film is obtained. The gel film thus obtained is peeled-off from the substrate, and by promoting a polymerization reaction by gradually increasing a temperature up to 300°C to 450°C or around in a heating furnace, and thus the laminated plastic film having the base body plastic film layer and the thermoplastic film layer is manufactured.

Next, the step of sequentially molding the base body plastic film and the thermoplastic film will be explained.

In this case, first, the precursor of the base body plastic film is formed on the substrate, and the precursor molding film is heated and dried at 80°C to 140°C or around to evaporate the solvent, thereby partially promoting the polymerization, to obtain the self-supporting gel film. The gel film thus obtained is peeled-off from the substrate, and by gradually increasing the temperature up to 300°C to 450°C or around in the heating furnace, the polymerization reaction is promoted, to obtain the base body plastic film layer. Next, the precursor of the thermoplastic film is formed on the base body plastic film layer thus manufactured, and the precursor molding film is heated and dried at 80°C to 140°C or around to evaporate the solvent. Further, the temperature is gradually increased up to 300°C to 450°C or around in the heating furnace, thereby promoting the polymerization, and thus the laminated plastic film having the thermoplastic film layer laminated on the base body plastic film layer is manufactured.

The laminated plastic film manufactured in the above-described method is set on a temperature controllable supporting stand having a heating and cooling mechanism. Then, the temperature is controlled in a temperature range from the temperature lower than the glass transition temperature (Tg) of the thermoplastic film by 100°C to lower than a decomposition temperature of the thermoplastic film. Then, the metal layer is formed on the thermoplastic film by the vapor deposition method. As a method of applying the metal layer, a sputtering method or an ion plating method out of the vapor deposition method is preferable, because a high adhesiveness is thereby obtained.

Further, when the temperature for applying the metal layer is set in a range from the temperature lower than the glass transition temperature (Tg) by 100°C to the glass transition temperature (Tg), an average roughness of the laminated plastic film Ra becomes 0.08 or less, and thus the laminated plastic film with high transparency can be obtained. When the laminated plastic film with high transparency is processed into a TAB tape and so forth, an optical positioning can be easily performed in a positioning step, and a chip mounting, an operability of wiring, and productivity are improved and thus a preferable structure is obtained.

Next, the metal layer can be formed up to a predetermined thickness on the metal layer (referred to as a seed layer in some cases hereafter) on the thermoplastic film formed by using the vapor deposition method, by electrolytically plating or electroless-plating, and thus the metal layer having a desired film thickness can be applied with good productivity by forming the metal layer using the plating method.

In addition, as a pre-treatment before forming the seed layer as needed, the laminated plastic film is previously applied with a corona discharge and a glow discharge, and by adding a functional group on the surface of the thermoplastic film, further preferably the adhesive strength between the seed layer and the thermoplastic film can be increased.

Further, when a silane compound such as a silane coupling agent and tetramethoxysilane, or an organic substance such as a silanol compound obtained by hydrolyzing the aforementioned silane compound is applied and deposited on the previously laminated plastic film and thereafter the seed layer is formed on the thermoplastic film, preferably the adhesive strength between the seed layer and the thermoplastic film can be further increased.

As an organic substance to be deposited on the laminated plastic film, the silane compound such as silane coupling agent and tetramethoxysilane, or a substance containing an element Si such as a silanol compound obtained by hydrolyzing the aforementioned silane compound are given as examples. However, the element Ti and the element Al may be satisfactory other than the element Si, or a mixture of these elements may be satisfactory. Namely, the compound such as Al coupling agent, Ti coupling agent, trimethoxy Al, and tetramethoxy Ti, and the mixture of them can be suitably used.

By way of example an explanation is given to a case of using the silane compound such as silane coupling agent, or using the silanol compound. However, the same thing can be said for Al-containing organic substance and Ti-containing organic substance.

An explanation will be given to an example of a method of applying the silane compound such as the silane coupling agent and the silanol compound, on the thermoplastic film so as to be deposited thereon.

First, the laminated plastic film having heat resistance which is high enough to withstand the treatment as will be described later is prepared. Then, the laminated plastic film is set in a heating furnace, then is heated and dried at 150°C to 300°C, while allowing dried nitrogen gas to flow therein, and the laminated plastic film is continuously heated at 150°C to 400°C.

Meanwhile, gasification is caused to occur by heating the organic substance such as silane coupling agent, silane compound, or silanol compound at 150°C to 400°C. Then, the silane coupling agent thus gasified is blown to the laminated plastic film for a predetermined time. Thereafter, the laminated plastic film is cooled up to a room temperature or around, while allowing dried nitrogen gas to flow in the heating furnace.

Also, after setting the laminated plastic film in the heating furnace, the laminated plastic film may be heated and dried at 150°C to 300°C, while allowing the dried nitrogen gas to flow in the heating furnace, to simplify the aforementioned method, and at the same time, the organic substance such as silane coupling agent, silane compound, or silanol compound heated and gasified at 150°C to 400°C, may be blown thereto, and thereafter the laminated plastic film may be cooled up to a room temperature or around, while allowing the dried nitrogen gas to flow therein.

By allowing the organic substance such as silane coupling agent, silane compound, or silanol compound to be deposited on the laminated plastic film, as an undercoat layer for improving a heat-resistant adhesiveness as will be describe later, it is possible to eliminate the step of providing a layer containing metal or alloy of more than one kind of elements selected from Cr, Ni, Mo, W, V, Ti, Si, Fe and Al, for example, as a seed layer. By eliminating the seed layer, it becomes possible to simplify a further etching step in the post process, thereby contributing to an improvement of the productivity, and this is preferable.

The reason for improving the heat-resistant adhesiveness between the laminated plastic film and the metal layer even if eliminating the step of providing the seed layer by allowing the organic substance to be gasified and deposited on the laminated plastic film as described above, is not clarified. However, it appears that when the organic substance is heated and coating is deposited on the laminated plastic film, a reaction occurs to improve a bonding property between the organic substance and the thermoplastic film.

As described above, a discharging process and a coating process of silane compound, etc, may be performed in combination, or only one of them may be performed. In either way, an advantage of further enhancing the adhesive strength between the thermoplastic film and the seed layer can be further obtained.

As the metal contained in the seed layer which is applied on the laminated plastic film, copper or an oxidation resistant alloy such as a phosphor bronze or brass containing copper as a main phase is preferable, from the point of a cost and processability. As other metal, for example, Al and stainless can also be suitably used, although not limited thereto.

Further, as a structure of not performing a deposition treatment of the organic substance, an undercoat layer may be provided in a part of a lowermost layer contacting the thermoplastic film layer in the aforementioned seed layer. When the structure of providing the undercoat layer in the seed layer is adopted, the layer containing the metal or alloy of more than one kind of element selected from Cr, Ni, Mo, W, V, Ti, Si, Fe, and Al as an undercoat layer can be selected, for example. When the structure of providing the undercoat layer is adopted, the undercoat layer of Cr and Ni, etc, may be formed on the aforementioned temperature-controlled laminated plastic film by the vapor deposition method, and further the metal layer having the oxidation resistant alloy such as copper or phosphor bronze and brass containing the copper as a main phase may be formed on the undercoat layer.

By adopting this structure, a high temperature stability of an adhesive force between the seed layer and the thermoplastic film layer can be further improved. Here, in order to maintain an etching property in a good condition for forming a circuit on the metal-coated substrate, the thickness of the metal of the undercoat layer is preferably set in a range from 10 to 500 Å.

Irrespective of the existence or non-existence of the undercoat layer of the Cr and Ni, etc, the thickness of the seed layer is preferably set at 1000 Å or more.

Meanwhile, when manufacturing the metal-coated substrate applied with metal coat on both sides of the laminated plastic film, the aforementioned metal coat treatment may be performed side by side, or can be performed on both sides simultaneously.

Here, by controlling the temperature of the laminated plastic film in a range from the temperature lower than the glass transition temperature (Tg) of the thermoplastic film by 100°C to lower than a decomposition temperature of the thermoplastic film, the adhesive strength and stability between the seed layer and the thermoplastic film layer can be significantly improved. A temperature control thus described may be performed by controlling the temperature of the supporting stand on which the laminated plastic film is set, or setting a thermal capacity, thermal conductivity, and heat dissipating properties of the supporting stand at predetermined values, thereby balancing with an energy light emitted by sputtering or ion plating. Then, a measurement of the temperature of the thermoplastic film can be performed by pasting a thermocouple and a temperature measurement tape to the thermoplastic film itself and/or the supporting stand with which the thermoplastic film is brought into contact.

In addition, in order to obtain the metal-coated substrate having a further adhesive stability as a bent part of a cellular phone, etc, the temperature range of the laminated plastic film during forming the seed layer on the laminated plastic film may be controlled in a range from the temperature lower than the glass transition temperature (Tg) of the thermoplastic film in the laminated plastic film by 50°C to lower than a decomposition temperature of the thermoplastic film. For example, when the thermoplastic having the glass transition temperature (Tg) of 180°C or more is selected, and the deposition treatment of the seed layer is performed in the aforementioned temperature range, the metal-coated substrate maintaining a high adhesiveness of 0.8N/mm or more can be obtained at a low cost, even after heating treatment for one hour at 180°C.

In addition, when the metal is laminated on only one side as shown in Fig.1, the ratio of the thermoplastic film layer and the base body plastic film layer in the laminated plastic film is preferably thermoplasticity : base body = 1 : 100 to 2 : 3. By setting the ratio of the thermoplastic film and the base body plastic film at 1 : 100 or more, the adhesiveness of more than predetermined value is obtained between the seed layer and the thermoplastic film, and by setting the ratio at 2 : 3 or less, the mechanical strength of the whole base body of the laminated film is prevented from deteriorating. When the metal is applied on both sides of the laminated plastic film as shown in Fig.2, preferably the thickness of each thermoplastic film provided on both sides of the laminated plastic film is within the aforementioned range.

For example, when a polyimide film having the glass transition temperature (Tg) of 180°C or higher is used, the metal-coated substrate having high mechanical strength and high heat-resistant property can be obtained. As the precursor of the polyimide film in this case, by reacting a diamine component and a tetracarboxylic dianhydride in nearly equivalent molar quantities in an organic solvent, a polyamic acid solution is prepared, and the polyamic acid solution thus prepared is preferably used.

Examples of the tetracarboxylic dianhydride include pyromellitic dianhydride, oxydiphthalic dianhydride, biphenyl-3,4,3'4'-tetracarboxylic dianhydride, biphenyl-2,3,3',4'-tetracarboxylic dianhydride, benzophenone-3,4,3',4'-tetracarboxylic dianhydride, diphenylsulfone-3,4,3',4'-tetracarboxylic dianhydride, 4,4'-(2,2-hexafluoroisopropylidene) diphthalic dianhydride, m(p)-terphenyl-3,4,3',4'-tetracarboxylic dianhydride, cyclobutane-1,2,3,4-tetracarboxylic dianhydride, 1-carboxymethyl-2,3,5-cyclopentane tricarboxylic acie-2,6:3,5-dianhydride, 2,2-bis(3,4-dicarboxyphenyl)propanedianhydride, bix(3,4-dicarboxyphenyl)ether dianhydride, bis(3,4-dicarboxyphenyl)sulfone dianhydride, 2,3,6,7- naphthalene tetracarboxylic dianhydride, and the like. Mixtures of two or more types selected from these compounds may also be used, but these examples are not limiting.

Examples of the diamine component include 1,4-diaminobenzene, 1,3-diaminobenzene, 2,4-diaminotoluene, 4,4'-diaminodiphenyl methane, 4,4'diaminodiphenyl ether, 3,4'-diaminodiphenyl ether, 3,3'-dimethyl-4,4'-diaminobiphenyl, 2,2'-dimethyl-4,4'-diaminobiphenyl, 2,2'-bis(trifluoromethyl)-4,4'-diaminobiphenyl, 3,7-diamino-dimethyldibenzothiophen-5,5-dioxide, 4,4'-diaminobenzophenone, 3,3'-diaminobenzophenone, 4,4'-bis(4-aminophenyl) sulfide, 4,4'-bis(4-aminophenyl)diphenylmethane, 4,4-bis(4-aminophenyl)diphenyl ether, 4,4'-bis(4-aminophenyl)diphenyl sulfone, 4,4-bix(4-aminophenyl)diphenyl sulfide, 4,4'-bis(4-aminophenoxy)diphenyl ether, 4,4'-bis(4-aminophenoxy)diphenyl sulfone, 4,4'-bis(4-aminophenoxy)diphenyl sulfide, 4,4'-bis(4-aminophenoxy)diphenyl methane, 4,4'-diaminodiphenyl sulfone, 4,4'-diaminodiphenyl sulfide, 4,4'-diaminobenzanilide, 1,n-bis(4-aminophenoxy)alkanes(n=3,4, and 5), 1,3-bis(4-aminophenoxy)-2,2-dimethyl propane, 1,2-bis(2-(4-aminophenoxy)ethoxy)ethane, 9,9-bis(4-aminophenyl)fluorine, 5(6)-amino-1-(4-aminomethyl)-1.3.3-trimethyl indane, 1,4-bis(4-aminophenoxy)benzene, 1,3-bis(4-aminophenoxy)benzene, 1,3-bis(3-aminophenoxy)benzene, 4,4'-bis(4-aminophenoxy)biphenyl, 4,4'-bis(3-aminophenoxy)biphenyl, 2,2-bis(4-aminophenoxyphenyl)propane, 2,2-bis(4-aminophenyl)propane, bis[4-(4-aminophenoxy)phenyl]sulfone, bis[4-(3-aminophenoxy)phenyl]sulfone, 2,2-bis[4-(aminophenoxy)phenyl]propane, 2 2,2-bis[4-(4-aminophenoxy)phenyl]hexafluoropropane, 3,3'-dicarboxy-4,4'-diaminodiphenyl methane, 4,6-dihydroxy-1,3-phenylenediamine, 3,3'-dihydroxy-4,4'-diaminobiphenyl,3,3,4,4'-tetraaminobip henyl, 1-amino-3-aminomethyl-3,5,5-trimethyl cyclohexane, 1,3-bis(3-aminopropyl)-1,1,3,3-tetramethyl disiloxane, 1,4-diaminobutane, 1,6-diaminohexane, 1,8-diaminooctane, 1,10-diaminodecane, 1,12-diaminododecane, 2,2'-dimethoxy-4,4'-diaminobenzanilide, 2-methoxy-4,4'diaminobenzanilide, and other aromatic diamines, aliphatic diamines, xylene diamines, and the like. Mixture of two or more types selected form these compounds may also be used, but these examples are not limiting.

Examples of organic solvents that are suitable for use in manufacturing the polyamic acid include N-methyl-2-pyrrolidone, N,N-dimethylformamide, N,N-dimethylacetamide, N,N-diethylacetamide, dimethyl sulfoxide, hexamethyl phosphoramide, N-methyl caprolactam, cresols, and the like. These organic solvents may be used singly or in mixtures of two or more types thereof, but these examples are not limiting.

Suitable cyclizing agents include dicarbosylic anhydrides and mixtures of two or more types of dicarboxylic anhydrides; trimethyl amines, triethyl amines, and other aliphatic tertiary amines; isoquinolines, pyridines, beta picolines, and other heterocyclic tertiary amines and the like; and mixtures of two or more types of the aliphatic tertiary amines and the heterocyclic tertiary amines may also be used, but these examples are not limiting.

In the metal-coated substrate according to the present invention, it is preferable to select a combination whereby the difference in linear expansion coefficients between the metal layer and the laminated plastic film becomes 15 × 10⁻⁶/K or less, when examining a material selection of the coated metal layer and the laminated plastic film. By selecting the difference in linear expansion coefficients between the metal layer and the laminated plastic film at 15 × 10⁻⁶/K or less, curling of the laminated plastic film during metal coating, and a stress generated during heat-treatment of the metal-coated substrate can be reduced, and as a result, preferably the thermal stability of the metal-coated substrate can be improved. As an example of the combination of the metal layer and the laminated plastic film, when the metal layer is copper, for example, the laminated plastic film having the linear expansion coefficients of 1.6 to 31.6 × 10⁻⁶/K is preferably selected, because the copper has the linear expansion coefficients of 16. 6 × 10⁻⁶/K in the vicinity of 300K. Further, as the laminated plastic film, by selecting the laminated plastic film having the pulling elasticity modulus of 1000 MPa or more, the metal-coated substrate with high reliability can be obtained.

Here, according to the present invention, the linear expansion coefficients are obtained by measuring in a direction (this direction is referred to as MD direction hereafter) vertical to the direction supported for the heat treatment of the precursor during manufacturing the plastic film, when the temperature of the plastic film to be measured is decreased from 200°C to 20°C at a 5°C/min. The pulling elasticity modulus is measured in accordance with ASTM D882 in the MD direction of the plastic film.

As a combination of the diamine component and the tetracarboxylic dianhydride suitable for manufacturing the laminated plastic film having the pulling elasticity modulus of 1000 MPa or more and the linear expansion coefficients of 10 to 23 × 10⁻⁶/K, the combination mainly composed of biphenyl-3,4,3',4'-tetracarboxylic dianhydride as the tetracarboxylic dianhydride, and 1,4-diaminobenzene as the diamine component can be given as examples. It is preferable to contain 50% or more of these components as the diamine component and as the tetracarboxylic dianhydride. The other component can be replaced with one kind or more of the diamine component and the tetracarboxylic dianhydride.

In addition, if desired, polyamide acid is firstly applied on a base material, and the base material applied with the polyamide acid is dried to manufacture the self-supporting gel film. Next, a predetermined extension process is performed by fixing the end of this film, thereby extending the film vertically and horizontally, and thus the linear expansion coefficients of this film are made to be closed to the linear expansion coefficients of the metal for coating the film.

It is preferable to obtain the metal-coated substrate in such a way that on the metal layer formed by the vapor deposition method on the laminated plastic film, the same kind or different kind of metal layer is further laminated by the plating method. According to the plating method, the thickness of the metal layer and the kind of the metal can be freely selected and efficiently controlled.

The metal layer of the metal-coated substrate thus obtained is subjected to metal processing such as an etching processing, and by forming a predetermined circuit pattern on the part of the metal layer, for example, a flexible circuit board and a flexible wiring board can be obtained.

Further, when the metal processing is performed by etching, it is preferable that the predetermined circuit pattern is formed by providing a resist film on the metal layer formed by the vapor deposition method, and the same kind or different kind of the metal layer is laminated by the plating method on the metal layer formed with the circuit pattern thereon. According to this structure, the metal layer laminated by the plating method is laminated only on the part not provided with the resist film. As a result, only by removing the resist film after completing the plating method and by etching and removing the metal layer under the resist film, the etching processing is completed. Therefore, even when the pitch of the circuit pattern is narrower, the metal layer can be made thick, and the circuit pattern with high fineness and low resistance can be formed.

Next, examples of a specific manufacturing method for obtaining the metal-coated substrate (referred to as "copper-clad flexible substrate" hereafter in some cases) as an embodiment will be explained.

### Examples

### (Example 1)

### (1) A manufacturing method of a precursor of polyimide as a base

Under a nitrogen stream, 108g of 1,4-diaminobenzene, and 294g of biphenyl-3,4,3',4'-tetracarboxylic dianhydride are added to 1800g of N,N-dimethylacetamide in a polymerization reactor, stirred therein, and a poliamide acid solution was thereby manufactured. Then, by adding 0.5g of colloidal silica to 100g of polyamide acid solution, the precursor of the polyimide as a base body was manufactured.

### (2) A manufacturing step of thermoplastic polyimide precursor

Under a nitrogen stream, 292g of 1,3-bis(3-aminophenoxy)benzene and 294g of 3,4,3',4'-tetracarrboxylic dianhydride are added to N,N-dimethylacetamide in a polymerization reactor, and stirred for 20 hours, and the polyamide acid solution was thereby manufactured. Next, by adding 5g of phthalic acid to the polyamide acid solution and stirred for further 3 hours, and the thermoplastic polyimide precursor was thereby manufactured. The glass transition temperature (Tg) of the thermoplastic polyimide thus manufactured from the thermoplastic polyimide precursor was 220°C.

### (3) A film forming step of a precursor of a polyimide film

By casting and coating the polyimide precursor thus manufactured on a flat and smooth substrate having not more than 0.02 µm surface average roughness Ra, a laminate was formed. In casting and coating, a two-layer extrusion die was used, and by casting and coating, the laminate was formed, so that the film thickness of the precursor of the polyimide as a base body manufactured in the "(1) A manufacturing method of a precursor of polyimide as a base body" is set at 100 µm, and the film thickness of the thermoplastic polyimide precursor manufactured in the "(2) A manufacturing step of thermoplastic polyimide precursor" is set at 25 µm, and further the precursor of the polyimide as a base body was on the side of the substrate. Next, the laminate thus formed was dried for 10 minutes at 120°C for 10 minutes, to form a self-supporting laminate. Then, a polyimide precursor coating film was peeled off from the substrate on the interface between the substrate and the thermoplastic polyimide, and the polyimide film precursor was thereby manufactured.

### (4) Heat treatment step of casting and coating

The polyimide film precursor thus obtained was set in a heating furnace, with both ends thereof supported, and retained for 10 minutes after gradually raising the temperature up to 350°C, and the polyimide film precursor is dehydrated, the solvent is removed, and an imide is formed. The polyimide film thus obtained became a laminated plastic film having thickness of about 25µm, wherein the polyimide as a base body and the thermoplastic polyimide are firmly joined to each other.

In order to measure the linear expansion coefficients of the polyimide film as a base body, by using only the polyimide precursor as a base body manufactured by the aforementioned "(1) A manufacturing method of a precursor of polyimide as a base", a film was formed by casting and coating this polyimide precursor on the flat and smooth substrate having not more than 0.02µm surface average roughness Ra by using the extrusion die, so that the film thickness of the polyimide precursor as a base body became 100 µm. Next, the film thus formed was dried for 10 minutes at 120°C, to form the self-supporting film, and the polyimide precursor coating film as a base body was peeled off from the substrate, to thereby manufacture the polyimide film precursor. The heat treatment step was carried out in the same way as the aforementioned (4) Heat treatment step of casting and coating. When the linear expansion coefficients and the pulling elasticity modulus in the MD direction of the polyimide film as a base body thus manufactured were measured, the linear expansion coefficients was 13 × 10⁻⁶/K, and the pulling elasticity modulus was 8000MPa, respectively.

### (5) Sputtering film forming step

The film of Cr and the film of copper were formed by sputtering on a thermoplastic polyimide surface of the laminated plastic film manufactured in the step (4) under the following condition.

First, the laminated plastic film was set, so that its thermoplastic polyimide surface was a target side, in a sputtering apparatus wherein targets of Cr and copper were set. Next, after exhausting a vacuum chamber of the sputtering apparatus up to 10⁻⁴Pa, argon gas was introduced, and a total pressure was set at about 0.4Pa. In this state, by adding an output power 2KW, the film of Cr was formed in the film thickness of 50 Å, and next,'the film of copper was formed in the film thickness of 2000 Å. During forming the films, the temperature of the film supporting stand was controlled, so that the temperature of the laminated plastic film was maintained to either of two levels of 200°C or 260°C.

### (6) Plating film forming step

About 5 µm of bright copper was plated on the laminated polyimide film with sputter coating manufactured as described above, at current density of 2A/dm² by using a plating solution (copper sulfate plating bath BMP-CUS by World Metal Co. , Ltd.), and a ultra-thin copper-clad flexible substrate having excellent adhesive strength between the film and the metal layer was manufactured.

### (7) Etching property evaluation step

The aforementioned copper-clad flexible substrate was subjected to etching at a pattern interval of 30 µm, and a circuit board was thus obtained. After applying an electroless plating treatment to the circuit board thus obtained, a voltage of 100 V was applied and an insulating resistance value was measured. It was found that each sample had a high insulating resistance value of 10¹¹ Ω or more.

### (8) Adhesiveness evaluation

An evaluation of an adhesiveness was performed by increasing the thickness of a copper metal layer of the copper clad flexible substrate up to 30 µm, because the strength of the copper metal layer was required in a peeling test. The test was performed pursuant to the peeling test in 90° direction of JIS C6471, before and after heating the sample at 180°C for one hour. As a result, as shown in table 1, a significantly high adhesion strength was obtained before and after heat treatment.

### (9) Surface roughness evaluation

At the time of the adhesiveness evaluation of (8), the surface roughness of a peeled surface of the plastic film layer in the evaluation sample which was peeled at an interface between the laminated plastic film and the metal layer was evaluated. Then, it was found that an average roughness of the sample having the plastic film formed at 200°C lower than 220°C, which was the glass transition temperature (Tg) of the plastic film, was 0.06 µm, and the sample had a high transparency. Meanwhile, the average roughness of the sample having the plastic film formed at 260°C, which was higher than the glass transition temperature (Tg) of the plastic film, was 0.32 µm, and the sample had a low transparency. The result is shown in table 1.

Note that in measuring the surface roughness, a super focal depth form measuring microscope VK-8500 by Keyence Corporation was used, to select a typical part of the plastic film and observe the range of 149 × 112 µm at a measurement range 0.02 µm and black and white super focal depth. Next, 5 points of the range of 20 × 20 µm were arbitrarily selected from this measurement range, the average roughness Ra of the range thus selected was measured, and the average value thereof was defined as a measurement value.

### (Example 2)

In the same way as the example 1, each step of:
(1) manufacturing the precursor of polyimide as a base body
(2) manufacturing the thermoplastic polyimide precursor
(3) manufacturing the polyimide film precursor
(4) heat treatment of casting and coating was performed, to manufacture the laminated plastic film having the thickness of about 25 µm wherein the polyimide as a base body and the thermal plastic polyimide were firmly joined to each other.
   The laminated plastic film thus manufactured in the aforementioned (4) was cut into width of 20 mm and length of 150 mm, and set in an apparatus whereby an evaporated gaseous organic substance is deposited on the plastic film. Thus, the gaseous organic substance was deposited on the surface of the plastic film. In this example, the silane coupling agent was used as the organic substance containing Si.
   The apparatus whereby the vaporized gaseous organic substance is deposited on the plastic film shown in Fig. 3 will be explained here.
   According to the apparatus whereby the vaporized gaseous organic substance is deposited on the plastic film, in a heating furnace 10, a metal container 21 filled with an organic substance (coupling agent) 22 and a metal container 31 having a laminated plastic film 32 contained therein are set. To these metal containers, a heat resistant hose 40 is connected. The hose 40 is diverted into two from a hose inlet 41 to become a hose 47, and the hose 44 of one of them is connected to the metal container 21 through a valve 51, while keeping an air-tight state. A hose 45 and a hose 46 are air-tightly connected to the metal container 21, and the hose 45 reaches a hose outlet 42 through a valve 53, and the hose 46 is air-tightly connected to the metal container 31. The other hose 47 is also connected to the metal container 31 through a valve 52, while keeping the air-tight state. Further, a hose 48 is connected to the metal container 31 while keeping the air-tight state to reach a hose outlet 43.
   First, nitrogen gas of purity 5N for organic substance transportation is flown at a rate of 5L/min from the hose inlet 41 at a room temperature, and by opening all valves 51 to 53, an atmosphere in the hose 40 and the metal containers 21 and 31 is replaced with the nitrogen gas. Next, the valve 51 is closed, with the valves 52 and 53 opened, the temperature of the heating furnace is increased to 200°C and retained for 60 minutes, while introducing the nitrogen gas into the metal container 31 at a rate of 5L/min, and humidity and a volatile organic substance component in the laminated plastic film 32 is dried.
   Next, the valves 52 and 53 are closed, while keeping the temperature of the heating furnace at 200°C, and by opening the valve 51, the flow of the nitrogen gas is guided to the metal container 21 having an organic substance 22 contained therein. Then, a vaporized organic substance 22 is transported to the metal container 31 through the hose 46 and sprayed on the laminated plastic film 32 for 1 minute. Thereafter, the valve 51 is closed, and by opening the valves 52 and 53, the temperature in the metal container 31 is increased up to 300°C while the nitrogen gas is introduced therein at a rate of 5L/min and retained for 20 minutes, and thereafter the temperature is cooled up to a room temperature, and thus the laminated plastic film on which the organic substance is deposited and coated was obtained. Here, as the organic substance 22, an amino-based silane coupling agent 3-triethoxysilyl-N-(1,3-dimethyl-butylydene)propylamine (production No.KBE-9103 by Shin-Etsu Chemical Co., Ltd.) was used.
(5) Sputtering film forming step
   The film of copper was formed on the manufactured thermoplastic polyimide surface of the laminated plastic film, on which the silane coupling agent was applied, by sputtering under the condition described below.
   First, in a sputtering apparatus having a target of copper is set therein, the laminated plastic film was set, with the thermoplastic polyimide surface thereof set as a target side. Next, after the vacuum chamber of the sputtering apparatus was exhausted up to 10⁻⁴ Pa, argon gas was introduced to set the total pressure at about 0.4 Pa, and by applying the voltage of 2kV, the film of copper was formed in the thickness of 2000Å. During forming this film, the temperature of the film supporting stand was controlled, so that the temperature of the laminated plastic film was kept to either of the two levels of 193°C or 236°C.
(6) Plating film forming step
   About 5 µm of bright copper was plated on the laminated polyimide film with sputter coating manufactured as described above, at current density of 2A/dm² by using the plating solution (copper sulfate plating bath BMP-CUS by World Metal Co., Ltd.), and a ultra-thin copper-clad flexible substrate having excellent adhesive strength between the film and the metal layer was manufactured.
(7) Etching property evaluation step
   The aforementioned copper-clad flexible substrate was subjected to etching at a pattern interval of 30 µm by an etching solution consisting of ferric chloride solution, and a circuit board was thus obtained. After applying an electroless Sn plating treatment to the circuit board thus obtained, a voltage of 100 V was applied and an insulating resistance value was measured. It was found that each sample had a high insulating resistance value of 10¹¹ Ω or more.
(8) Adhesiveness evaluation
   An evaluation of adhesiveness was performed by re-plating and increasing the thickness of a copper metal layer of the copper clad flexible substrate up to 30 µm, because the strength of the copper metal layer was required in a peeling test. The test was performed pursuant to the peeling test in 90° direction of JIS C6471, before and after heating the sample at 180°C for one hour. As a result, as shown in table 1, a significantly high adhesion strength was also obtained before and after heat treatment.
(9) Surface roughness evaluation
   In the same way as the example 1, at the time of the adhesiveness evaluation of (8), the surface roughness of the peeled surface of the plastic film layer in the evaluation sample which was peeled at the interface between the laminated plastic film and the metal layer was evaluated as follows. Then, it was found that the average roughness of the sample having the plastic film formed at 193°C lower than 220°C, which was the glass transition temperature (Tg) of the plastic film, was 0.04 µm, and the sample had a high transparency. Meanwhile, the average roughness of the sample having the plastic film formed at 236°C, which was higher than the glass transition temperature (Tg) of the plastic film, was 0.26 µm, and the sample had a low transparency. The result is shown in table 1.
(10) A joining interface evaluation
   In the adhesiveness evaluation of the aforementioned (8), an existence ratio of Si in the range of diameter 0.8 mm in a depth direction of the metal layer from the peeled surface of the metal layer in the evaluation sample was measured by a photoelectron spectroscope (ESCA PHI5800 by Ulvac-Phi). Then, it was found that 0.5 mol% to 2 mol% of Si exist close to the range of 5nm and 10nm. Here, as a rate (digging distance) for digging by sputtering, by sequentially adding an energy (voltage of 4kV and inter-electron current of 25mA) whereby digging is possible at an interval of 5 nm for a SiO2 layer, digging was performed by sputtering up to 10 nm.

### (Reference example 1)

The reference example 1 is similar to the example 2, however, in the (5) sputtering film forming step, the film of Cr was firstly formed, and next, the film of Cu was formed.

First, in the same way as the example 1, each step of:
(1) manufacturing the precursor of polyimide as a base body
(2) manufacturing the thermoplastic polyimide precursor
(3) manufacturing the polyimide film precursor
(4) heat treatment of casting and coating was performed, to manufacture the laminated plastic film having the thickness of about 25 µm wherein the polyimide as a base body and the thermal plastic polyimide were firmly joined to each other. Then, in the same way as the example 2, the silane coupling agent was deposited on the laminated plastic film.
(5) Sputtering film forming step
   The film of Cr and the film of copper were formed by sputtering on a thermoplastic polyimide surface of the laminated plastic film on which the silane coupling agent thus manufactured was applied, under the following condition.
   First, the laminated plastic film was set, so that its thermoplastic polyimide surface was a target side, in a sputtering apparatus wherein targets of Cr and copper were set. Next, after exhausting the vacuum chamber of the sputtering apparatus up to 10⁻⁴Pa, argon gas was introduced, and a total pressure was set at about 0.4Pa. In this state, by adding the voltage of 2k V, the film of Cr was formed in the film thickness of 50 Å, and next, the film of copper was formed in the film thickness of 2000 Å. During forming the films, the temperature of the film supporting stand was controlled, so that the temperature of the laminated plastic film was maintained to either of two levels of 193°C or 236°C.
(6) Plating film forming step
   This step was executed in the same way as the example 2.
(7) Etching property evaluation step
   At a pattern interval of 30 µm on the aforementioned copper-clad flexible substrate, copper was subjected to etching by etching solution consisting of ferric chloride solution, and Cr was subjected to etching by etching solution containing potassium ferricyanide (K3Fe(CN)6) and potassium hydrate, and the circuit board thus obtained was subjected to electroless Sn plating. Thereafter, the voltage of 100V was applied to the circuit board and the insulating resistance value was measured, and it was found that each sample showed the insulating resistance value higher than 10¹¹Ω.
(8) Adhesiveness evaluation
   The evaluation of adhesiveness was performed in the same way as the example 2 and the result is shown in table 1.
   The result of the table 1 revealed almost the same extent of close adhesion between the reference example 1 and the example 2. From this result, it was found that by coating the surface of the laminated plastic film by the coupling agent containing a metal element, a film formation of Cr by sputtering could be omitted.
(9) Evaluation of surface roughness
   In the same way as the example 1, during the step of (8), i.e. when evaluating the close adhesion, the surface roughness of a peeled surface of the plastic film layer in an evaluation sample which was peeled at an interface between the laminated plastic film and the metal layer was evaluated. Then, it was found that the average roughness of the sample was 0.04µm when the film was formed at 193°C lower than 220°C, which was the glass transition temperature (Tg) of the plastic film of this example, and it was found that the sample had a high transparency.

Meanwhile, the average roughness of the sample was 0.27µm, when the film was formed at 236°C, which was higher than Tg, and it was found that the sample had a low transparency. The result is shown in table 1.

### (Reference example 2)

The reference example 2 is similar to the example 2, however, the silane coupling agent is not deposited on the laminated plastic film in the (4) heat treatment step of casting and coating, and the film of Cr was not formed in the (5) in the (5) sputtering film forming step.

First, in the same way as the example 1, each step of:
(1) manufacturing the precursor of polyimide as a base body
(2) manufacturing the thermoplastic polyimide precursor
(3) manufacturing the polyimide film precursor
(4) heat treatment of casting and coating was performed, to manufacture the laminated plastic film having the thickness of about 25 µm wherein the polyimide as a base body and the thermal plastic polyimide were firmly joined to each other.
(5) Sputtering film forming step
   The film of copper was formed by sputtering on a thermoplastic polyimide surface of the laminated plastic film on which the manufactured silane coupling agent was not applied.
(6) Plating film forming step
   The plating film forming step was performed in the same way as the example 2.
(7) Evaluation step of etching property
   At a pattern interval of 30 µm on the aforementioned copper-clad flexible substrate, copper was subjected to etching by etching solution consisting of ferric chloride solution, and the circuit board thus obtained was subjected to electroless Sn plating. Then, the voltage of 100V was applied thereto, to measure the insulating resistance value. It was found that each sample had a high insulating resistance value of 10¹¹Ω or more.
(8) Adhesiveness evaluation
   In the same way as the example 2, the evaluation of adhesiveness was performed and the result is shown in table 1.
   The result of the table 1 revealed that the reference example 2 had an almost the same extent of strength as that of the example 2 and the reference example 1 in adhesiveness before heat treatment, and had more deteriorated strength compared to the example 2 and the reference example 1 in adhesiveness after heat treatment. However, the reference example 2 was sufficiently applicable according to the purpose of use.
(9) Surface roughness evaluation
   In the same way as the example 1, during the step of (8), i.e. when evaluating the adhesiveness, the surface roughness of the peeled surface of the plastic film layer in an evaluation sample which was peeled at an interface between the laminated plastic film and the metal layer was evaluated. Then, it was found that the average roughness of the sample was 0.04µm when the film was formed at 193°C lower than 220°C, which was the glass transition temperature (Tg) of the plastic film of this example, and it was found that the sample had a high transparency.

Meanwhile, the average roughness of the sample was 0.24µm, when the film was formed at 236°C, which was higher than Tg, and it was found that the sample had a low transparency. The result is shown in table 1.

**(Table 1)**

| | COUPLING TREATMENT | SPUTTER FILM | SPUTTER FILM FORMING TEMPERATURE (°C) | ADHESIVENESS | | AVERAGE ROUGHNESS (*µ*m) | TRANSPARENCY |
|---|---|---|---|---|---|---|---|
| | | | | BEFORE HEAT TREATMENT (N/mm) | AFTER HEAT TREATMENT (N/mm) | | |
| EXAMPLE 1 | NOT NEEDED | Cr AND COPPER | 200 | | 1.2~1.6 | 0.06 | HIGH |
| | | | 260 | | 1.8~2.2 | 0.32 | LOW |
| EXAMPLE 2 | NEEDED | COPPER | 193 | 1.5~1.8 | 1.5~1.8 | 0.04 | HIGH |
| | | | 236 | 1.5~1.8 | 1.5~1.9 | 0.26 | LOW |
| REFERENCE EXAMPLE 1 | NEEDED | Cr AND COPPER | 193 | 1.4~1.8 | 1.5~1.8 | 0.04 | HIGH |
| | | | 236 | 1.5~1.8 | 1.5~1.7 | 0.27 | LOW |
| REFERENCE EXAMPLE 2 | NOT NEEDED | COPPER | 193 | 1.0~1.4 | 0.8~1.2 | 0.04 | HIGH |
| | | | 236 | 1.3~1.5 | 1.0~1.2 | 0.24 | LOW |

### (Comparative example 1)

In order to compare the examples 1 and 2, comparative examples were manufactured under the following conditions. Specifically, by using only the polyimide precursor as a base body which was manufactured in the step of "(1) manufacturing the precursor of polyimide as a base body" of the example, the film was formed on a flat and smooth substrate having surface average roughness Ra of 0.02µm or less by casting and coating using an extrusion die, so that the polyimide precursor as a base body had a film thickness of 100µm. Next, the laminated film thus obtained was dried for 10 minutes at 120°C to form a self-supporting film. Then, the polyimide precursor coating film as a base body was peeled from the substrate, and the polyimide film precursor was manufactured.

The heat treatment step was performed in the same way as the step of "(4) heat treatment of casting and coating". The sputter film forming step was performed by controlling the temperature of the film supporting stand, so that the temperature of the polyimide film could be maintained to about 150°C in the "(5) Sputtering film forming step". Hereunder, in the same way as the example, the step of "(6) Plating film forming step", the step of "(7) Evaluation step of etching property", and the "(8) Adhesiveness evaluation" were performed.

As a result, the copper-clad flexible substrate according to the comparative example 1 revealed the insulating resistance value of 10¹¹Ω or more, although having almost no adhesiveness of 0.1N/mm or less as for the adhesiveness after heating.

### (Comparative example 2)

Except that the film was formed by subjecting the polyimide film to RF plasma treatment, with power output of 100W before the sputter film forming step of the comparative example 1, in the same way as the comparative example 1, the copper-clad flexible substrate according to the comparative example 2 was manufactured, and the same evaluation as the comparative example 1 was performed and the result described hereunder was obtained.

As a result, it was found that the copper-clad flexible substrate according to the comparative example 2 had the insulating resistance value of 10¹¹Ω or more, although it had low adhesiveness of 0. 2 to 0.4N/mm as for the adhesiveness after heating.

### Brief description of the drawings

Fig.1 is a sectional view of a metal-coated substrate according to an embodiment of the present invention provided with a metal layer on one side.
Fig.2 is a sectional view of the metal-coated substrate according to a different embodiment of the present invention provided with a metal layer on both sides.
Fig.3 is a conceptional view showing an apparatus whereby an organic substance is deposited on a laminated plastic film.

### Description of signs and numerals

- 1: Metal layer formed by a vapor deposition method
- 2: Thermoplastic film layer
- 3: Base body plastic film layer
- 10: Heating furnace
- 21: Metal container
- 22: Organic substance
- 31: Metal container
- 32: Laminated plastic film
- 40: Hose
- 41: Hose inlet
- 42, 43: Hose outlet
- 43 to 48: Hose
- 51 to 53: Valve

## Claims

1. A metal-coated substrate, having a metal layer provided on one side or both sides of a laminated plastic film having a plurality of plastic film layers, the laminated plastic film comprising:
a plastic film layer as at least a base body; and
a thermoplastic film layer including thermoplastic,
wherein the plastic film layer as the base body has 15 × 10⁻⁶/K or less of a difference between linear expansion coefficients of the plastic film layer and the metal layer, and the metal layer is formed on the thermoplastic film layer by a vapor deposition method.

2. The metal-coated substrate according to claim 1, wherein a glass transition temperature of the thermoplastic contained in the thermoplastic film layer is 180° or more.

3. The metal-coated substrate according to either of claim 1 or 2, wherein the metal layer is formed, with a temperature of the laminated plastic film controlled at the temperature from the temperature lower than the glass transition temperature of the thermoplastic film by 100°C to lower than a decomposition temperature of the thermoplastic film.

4. The metal-coated substrate according to any one of claims 1 to 3, wherein more than one kind of elements selected form Si, Ti, and A1 are contained from a joining interface between the metal layer and the thermoplastic film layer toward the metal layer.

5. The metal-coated substrate according to any one of claims 1 to 4, wherein the vapor deposition method is a sputtering method or an ion plating method.

6. The metal-coated substrate according to any one of claims 1 to 5, wherein a pulling elasticity modulus of the laminated plastic film layer is 1000MPa or more.

7. The metal-coated substrate according to any one of claims 1 to 6, wherein the metal layer is further laminated by a plating method on the metal layer formed by the vapor deposition method.

8. A manufacturing method of a metal-coated substrate, which is the manufacturing method of the metal-coated substrate having a metal layer provided on one side or both sides of a laminated plastic film having a plurality of plastic film layers, comprising:
selecting a plastic film layer as a base body having a difference between linear expansion coefficients of 15 × 10⁻⁶/K or less of the laminated plastic film and the metal layer in the laminated plastic film;
forming a thermoplastic film containing thermoplastic on one side or both sides of the plastic film layer as a base body; and thereafter
forming the metal layer on the thermoplastic film layer by a vapor deposition method.

9. The manufacturing method of the metal-coated substrate according to claim 8, wherein when the metal layer is formed, a temperature of the laminated plastic film layer is controlled at the temperature from the temperature lower than the glass transition temperature of the thermoplastic film by 100°C to lower than a decomposition temperature of the thermoplastic film.

10. The manufacturing method of the metal-coated substrate according to claim 9, wherein before the metal layer is formed, an organic substance containing more than one kind of elements selected from Si, Ti, and Al is deposited on the thermoplastic film layer.

11. The manufacturing method of the metal-coated substrate according to claim 10, comprising the steps of:
allowing the organic substance containing more than one kind of elements selected from Si, Ti, and Al to be deposited on the thermoplastic film layer before the metal layer is formed; and
heat-treating at 150°C or more the laminated plastic film having the organic substance containing more than one kind of elements selected form the Si, Ti, and Al deposited thereon.

12. The manufacturing method of the metal-coated substrate according to claim 11, comprising the steps of:
allowing the organic substance containing more than one kind of elements selected form Si, Ti, and Al to be deposited on the thermoplastic film layer before the metal layer is formed; and
heat-treating at 150°C the laminated plastic film having the organic substance containing more than one kind of elements selected from the Si, Ti, and Al deposited thereon,
wherein the above two steps are simultaneously performed.

13. The manufacturing method of the metal-coated substrate according to any one of claims 8 to 12, wherein as a vapor deposition method for forming the metal layer, a sputtering method or an ion plating method is performed.

14. The manufacturing method of the metal-coated substrate according to any one of claims 8 to 13, comprising:
a plating film-forming step by a plating method for laminating the same kind or different kind of metal layer on the metal layer formed by the vapor deposition method.

15. The manufacturing method of the metal-coated substrate according to claim 14, wherein after the metal layer is formed by the vapor deposition method, or after the plating film forming step, by etching the metal layer, a predetermined circuit pattern is formed on the metal layer.

16. The manufacturing method of the metal-coated substrate according to either of claim 14 or 15, comprising the steps of:
forming a predetermined circuit pattern by providing a resist film on the metal layer formed by the vapor deposition method;
laminating the same or different kind of metal layer by a plating method on the metal layer having the circuit pattern formed thereon; and
removing the resist film, and removing the metal layer under the resist film thus removed,
wherein a predetermined circuit pattern is formed on the metal layer.
